# EUROPEAN PATENT APPLICATION

(11) **EP 1 209 249 A2**
(43) Date of publication of application: **29.05.2002**
(21) Application number: 01127414.9
(22) Date of filing: 23.11.2001
(51) Int. Cl.: C23C 16/44, H01L 21/00, B08B 7/00

(54) **Semiconductor manufacturing system and method for cleaning the same**

(30) Priority: 27.11.2000 JP 2000359045
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Kawai, Hideaki, Minatu-ku, Tokyo 108-0073 (JP); Tokumasu, Noboru, Minato-ku, Tokyo 108-0075 (JP); Azumi, Takyoshi, Minato-ku, Tokyo 108-0075 (JP)
(74) Representative: Schwabe - Sandmair - Marx

(57) **Abstract**

There is provided a semiconductor manufacturing system and a method for cleaning the same. Silicon oxide adhering to elements, which constitute the system, is removed by a cleaning gas containing HF gas and water vapor together with heating the elements.

## Description

### BACKGROUND OF THE INVENTION

### 1. Field of the Invention

The present invention relates to a semiconductor manufacturing system and to a method for cleaning the same and, more particularly, to a technology that is advantageous for cleaning a object to which the silicon oxide is adhered.

### 2. Description of Related Art

Various films are employed in the semiconductor device such as LSI, etc. Focusing on a silicon oxide film such as the SiO₂ film, etc., the CVD method (Chemical Vapor Deposition method) is usually employed to form this film. In the CVD method, the film is formed on the wafer by oxidizing or plasmanizing the film forming gas although such process is different according to the type of the film to be formed.

In forming the film, the wafer is placed in a reaction chamber and then the film forming gas is introduced into the chamber. At this time, since not only the surface of the wafer but also the wall of the chamber and various elements provided in the chamber are exposed to the above film forming gas, film (SiO₂ film, etc.) is formed also on these element.

In the initial stage, even if the film is formed in this manner, there is no problem because the thickness of this film is thin. However, if the films are laminated by repeating the film formation and thus the thickness of the laminated film increases, above elements can no longer perform their predetermined functions and thus the reliability of the CVD equipment is degraded. Therefore, it is usual in the CVD equipment to perform maintenance operation periodically in order to clean the equipment so as to remove the above excess films.

In the followings, method for cleaning the CVD equipment in the prior art will be explained in brief. The film, which is subjected to the cleaning, is the SiO₂ film and the BPSG film.

Step P1: The elements (objects to be cleaned) such as the suscepter (wafer holder), etc. to which these films are adhered are taken out from the chamber.

Step P2: The taken-out elements are immersed in the HF aqueous solution to remove the films. The typical HF concentration is given as HF:H₂O=1:10.

Step P3: The elements are pulled up from the HF aqueous solution and then rinsed with a great deal of water.

Step P4: The elements are dried sufficiently.

Step P5: The elements are fitted again to the inside of the chamber.

However, following problems have arisen in above steps.
① Steps P1 and P5
   Usually, a number of screws must be loosened to take out the elements from the chamber, and thus the maintenance time is prolonged. This is also the case where the elements are fitted to the inside of the chamber. However, if the maintenance time becomes long as above, the operation hours of the CVD equipment are shortened and therefore the productivity of the semiconductor devices such as LSI, etc. is reduced.
② Step P2
   If the HF concentration in the solution is high, waste product, which is produced when processing a waste HF solution, is increased. Since the increased waste product pollutes the environments in which the human being live, it is preferable to reduce the waste product as small as possible.
③ Step P3
   In order to rinse the residual HF from the elements, a large quantity of water is needed. From a viewpoint of protecting water resources and of reducing a water cost, it is preferable that an amount of consumed water is reduced.

### SUMMARY OF THE INVENTION

It is an object of the present invention to provide a semiconductor manufacturing system and the method for cleaning the same, that is capable of precluding the necessity of removing the object, to which silicon oxide is adhered, from the semiconductor manufacturing system, capable of reducing an amount of waste product than the prior art, and capable of decreasing an amount of consumed water.

According to the present invention, object to be cleaned, to which a silicon oxide is adhered, are heated and exposed to a cleaning gas containing an HF gas and a water vapor to remove the silicon oxide. In this case, the silicon oxide is removed according to the following reaction.

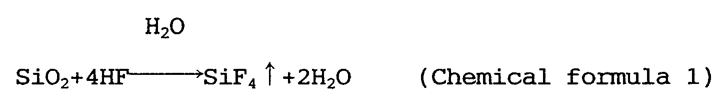

Since the boiling point of the SiF₄ in the right hand side is -95 °C, and since the object is heated, the SiF₄ does not remain on the object after the cleaning. In similar fashion, since the object is heated, H₂O in the right hand side does not remain on the object. Moreover, even if the unreacted HF is existing in the cleaning gas, the HF does not remain on the object since the boiling point of the HF is 20 °C (under the atmospheric pressure) and the object is heated. Therefore, there is no necessity in the present invention to rinse the object with water to remove the cleaning liquid and the coproduct.

In addition, since the water vapor is added to the cleaning gas, HF²⁻ is generated in the cleaning gas and thus the cleaning gas is activated. The cleaning of the object can be accelerated by this HF²⁻.

Further, the liquid component is hardly contained in the cleaning gas after the cleaning. This is because an amount of the water vapor to be added to the cleaning gas is minute, and because both HF and SiF₄ contained in the cleaning gas after the cleaning are gaseous at the room temperature (20 °C). Therefore, the cleaning gas after the cleaning can be processed by an adsorption-type exhaust gas processing system. In general, an amount of waste product that is discharged from the adsorption-type exhaust gas processing system is extremely smaller than that discharged when the HF aqueous solution is subjected to the waste liquid processing. As a result, in the present invention, an amount of waste product can be reduced than the prior art, and thus it is possible to reduce the possibility that the environment, in which the human beings live, is polluted by the waste product.

On the other hand, the semiconductor manufacturing system according to the present invention comprises the film forming gas discharging means, the cleaning gas discharging means, and the wafer holding means. When the film formation on the wafer is to be carried out, the wafer holding means is moved to the position at which the wafer is exposed to the film forming gas discharged from the film forming gas discharging means. Then, when the wafer holding means is to be cleaned, the wafer holding means is moved to the position at which the wafer holding means is exposed to the cleaning gas discharged from the cleaning gas discharging means. At this time, the wafer holding means does not hold the wafer. According to this, when the wafer holding means is to be cleaned, maintenance time of the system can be reduce since there is no need to remove the wafer holding means from the system as in the prior art.

Besides, the semiconductor manufacturing system according to another aspect of the present invention further comprises the water vapor supplying means for supplying the water vapor to the cleaning gas discharging means, and the HF gas supplying means for supplying the HF gas to the cleaning gas discharging means. According to this, the cleaning gas containing the HF gas and the water vapor is discharged from the cleaning gas discharging means, and the wafer holding means can be cleaned by this cleaning gas.

In this case, if the heating means for heating the wafer holding means is further comprised, the wafer holding means can be cleaned by the cleaning gas containing the HF gas and the water vapor under the condition where the wafer holding means is heated. According to this, as described above, there is no need to rinse the wafer holding means, which is one of the object to be cleaned, with water after the cleaning.

### BRIEF DESCRIPTION OF THE DRAWINGS

FIG.1 is a perspective view showing a semiconductor manufacturing system according to an embodiment of the present invention;
FIG.2 is a perspective view showing a film forming unit (film forming gas discharging means) provided to the semiconductor manufacturing system according to the embodiment of the present invention;
FIG.3 is a sectional view showing the film forming unit (film forming gas discharging means) provided to the semiconductor manufacturing system according to the embodiment of the present invention;
FIG.4 is a perspective view showing a heater unit provided to the semiconductor manufacturing system according to the embodiment of the present invention;
FIG.5 is a partially-sectioned perspective view showing the heater unit provided to the semiconductor manufacturing system according to the embodiment of the present invention;
FIG.6 is a perspective view showing a cleaning unit (cleaning gas discharging means) provided to the semiconductor manufacturing system according to the embodiment of the present invention;
FIG.7 is a top view showing a cleaning unit (cleaning gas discharging means) provided to the semiconductor manufacturing system according to the embodiment of the present invention;
FIG.8 is a sectional view showing the cleaning unit (cleaning gas discharging means) provided to the semiconductor manufacturing system according to the embodiment of the present invention;
FIG.9 is view showing routings of pipes provided to the semiconductor manufacturing system according to the embodiment of the present invention;
FIG.10 is a sectional view showing the film forming unit (film forming gas discharging means) and the heater unit when film formation is carried out by using the semiconductor manufacturing system according to the embodiment of the present invention;
FIG.11 is a perspective view showing a method for cleaning a semiconductor manufacturing system according to an embodiment of the present invention; and
FIG.12A to 12D are sectional views showing the method for cleaning the semiconductor manufacturing system according to an embodiment of the present invention.

### DESCRIPTION OF THE PREFERRED EMBODIMENTS

### (1) Explanation of a CVD equipment (semiconductor manufacturing system) according to an embodiment of the present invention

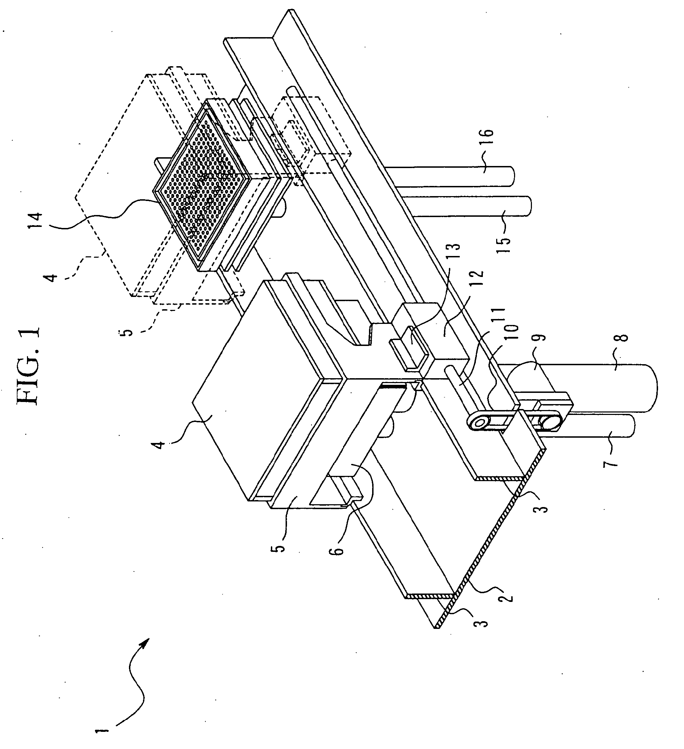

First of all, the CVD equipment (semiconductor manufacturing system) according to the present embodiment will be explained with reference to FIGS.1 to 9 hereunder.

The CVD equipment shown in FIG.1 has a base 2, and guide rails 3 are provided upright on the base 2. A carrier 5 is loaded on the guide rails 3 such that it can be slid in the longitudinal direction of the guide rails 3. As shown in FIG.1, the carrier 5 holds a heater unit 4, and this heater unit 4 has a holding means for holding the wafer in the face down state (this will be described in detail later). Sliders 12 are fixed to one side of the carrier 5 via L-shaped joints 13. 11 is a driving shaft, whose surface is threaded with a male screw.

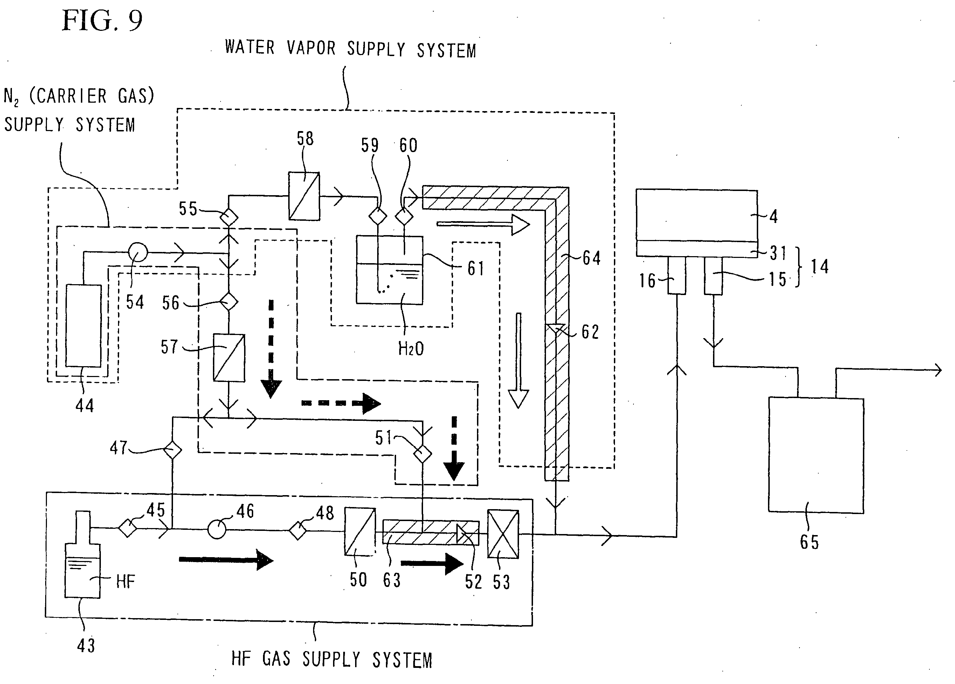

A female screw, although not particularly depicted, is cut in the sliders 12, and the male screw of the driving shaft 11 is screwed into this female screw. In FIG.1, 9 is a motor, and 10 is a belt that transmits a driving power of the motor 9 to the driving shaft 11. The driving shaft 11 is rotationally driven by this belt 10 and thus the slider 12 is horizontally moved along the longitudinal direction of the guide rail 3. By the motion of the sliders 12, the carrier 5 and the heater unit 4 are horizontally moved together along the longitudinal direction of the guide rails 3.

6 is a film forming unit (film forming gas discharging means) described in detail later, and this film forming unit 6 is fixed onto the base 2. A film forming gas is supplied from a film forming gas supply pipe 7 to the film forming unit 6 and then exhausted from a film forming gas exhaust pipe 8. In the arrangement shown in FIG.1, the heater unit 4 is positioned to cover this film forming unit 6, and a film is formed on the wafer, that is held on the heater unit 4, in this state.

14 is a cleaning unit (cleaning gas discharging means) for discharging a cleaning gas to clean the heater unit 4. When the heater unit 4 is to be cleaned, the heater unit 4 and the carrier 5 are moved together to the position indicated by a dotted line in FIG.1. The cleaning gas is supplied to the cleaning unit 14 via a cleaning gas supply pipe 16 and then exhausted from a cleaning gas exhaust pipe 15.

Next, details of the each portions of the above CVD equipment will be explained hereunder.

### ① Film forming unit 6

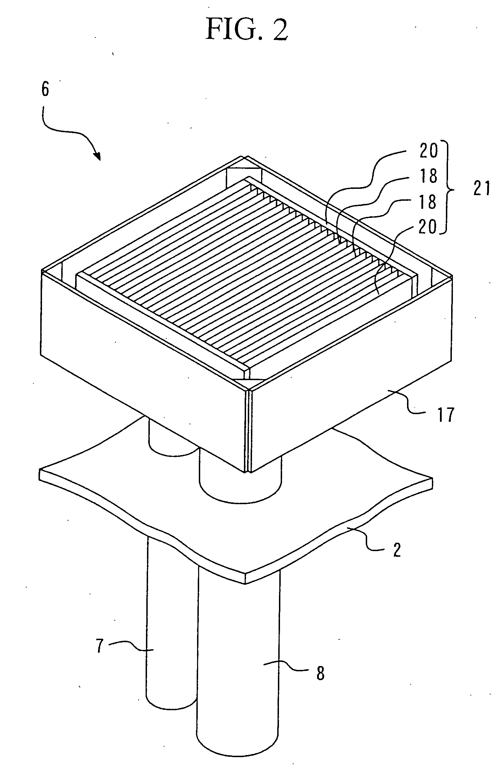

FIG.2 is a perspective view of the film forming unit 6. In FIG.2, 17 is an outer surrounding vessel, and a gas distributor 21 is housed in the vessel 17. This gas distributor 21 consists of a plurality of nozzle plates 18 and fixing plates 20 for fixing these nozzle plates 18.

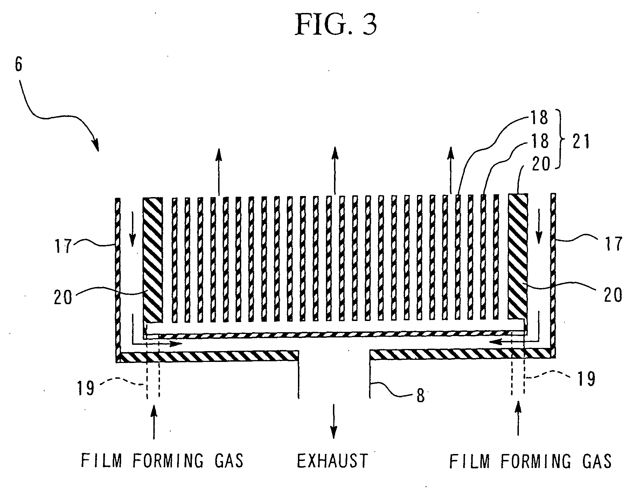

A cross section of this film forming unit 6 is shown in FIG.3. The film forming gas supply pipe 7 (see FIG.2) is branched into a plurality of branch pipes 19 shown in FIG.3 via a manifold (not shown). Since these branch pipes 19 are communicated with the gas distributor 21, the film forming gas that is passed through the branch pipes 19 is supplied to the gas distributor 21. Then, the supplied film forming gas is passed through each clearance between the nozzle plates 18, and then discharged upward from the film forming unit 6 in the vertical direction.

Although not explicitly shown in FIG.3, the discharged film forming gas blows against the wafer to change its propagating direction and then flows into a space between the outer surrounding vessel 17 and the fixing plates 20. Since this space is communicated with the exhaust pipe 8 and this exhaust pipe 8 is connected to an exhaust pump (not shown), the film forming gas is exhausted via the exhaust pipe 8.

### ② Heater unit 4

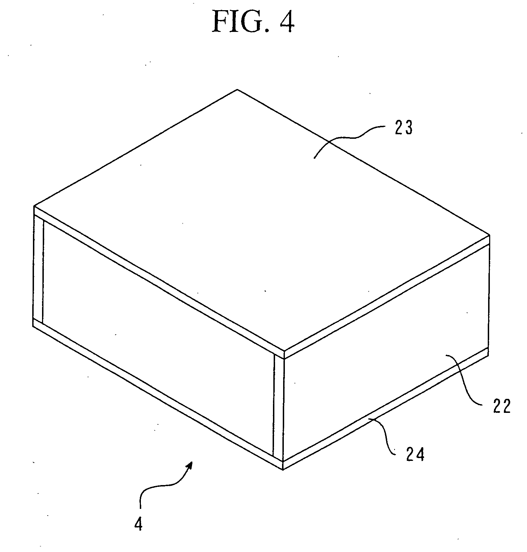

FIG.4 is a perspective view of the heater unit 4. In FIG.4, 23 is an upper plate, and 22 is a side plate. Then, 24 is a frame body.

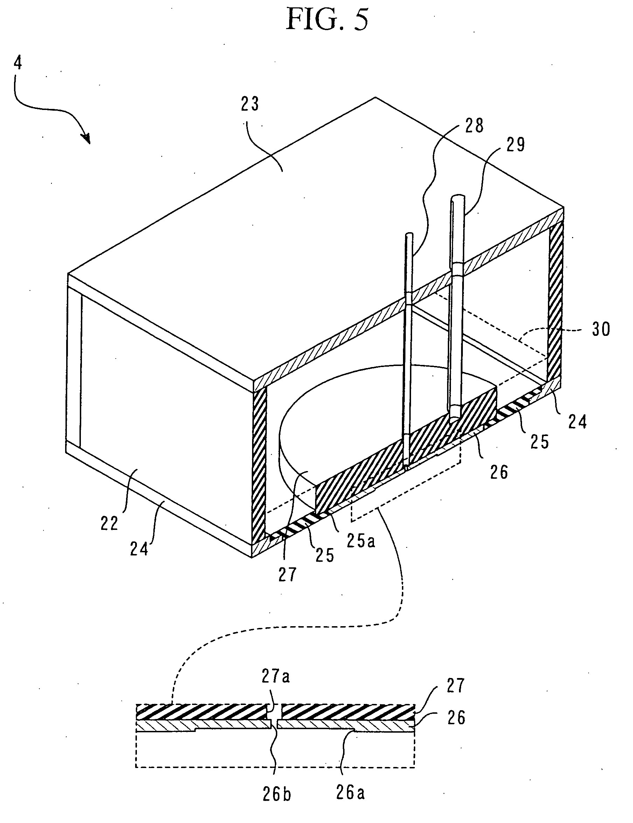

A partially-sectioned perspective view of this heater unit 4 is shown in FIG.5. As shown in FIG.5, the frame body 24 holds a protection plate 25 made of quartz. As described later, this protection plate 25 acts to prevent the film forming gas from entering into the inside of the heater unit 4. A circular opening portion 25a is opened in the protection plate 25, and a suscepter 26 (wafer holding means) made of silicon carbide (SiC) is fitted in the opening portion 25a. The suscepter 26 holds the wafer (not shown) by the vacuum chuck. A concave portion 26a for the vacuum chuck and an opening portion 26b that is communicated with the concave portion 26a are provided to a surface of the suscepter 26.

In FIG.5, 27 is a heater for heating the wafer via the suscepter 26. An opening portion 27a that is communicated with the opening portion 26b is opened in this heater 27, and a suction pipe 28 is fitted into the opening portion 27a. The suction pipe 28 is connected to a pump (not shown), and the wafer (not shown) can be held in the face down state by sucking the suction pipe 28 by the pump.

A heating wire (not shown) is buried in the heater 27, and the heater 27 is heated by supplying the current to the heating wire. The wafer temperature can be adjusted arbitrarily by adjusting the magnitude of the current supplied to this heating wire. As shown in FIG.5, because the protection plate 25 is brought into contact with this heater 27, the protection plate 25 is also heated at the almost same temperature as the wafer. In FIG.5, 29 is a pipe through which a lead (not shown) for supplying the current to the heating wire is passed, and 30 is a heat insulating material for preventing the leakage of heat of the heater 27 to the outside of the heater unit 4.

### ③ Cleaning unit 14

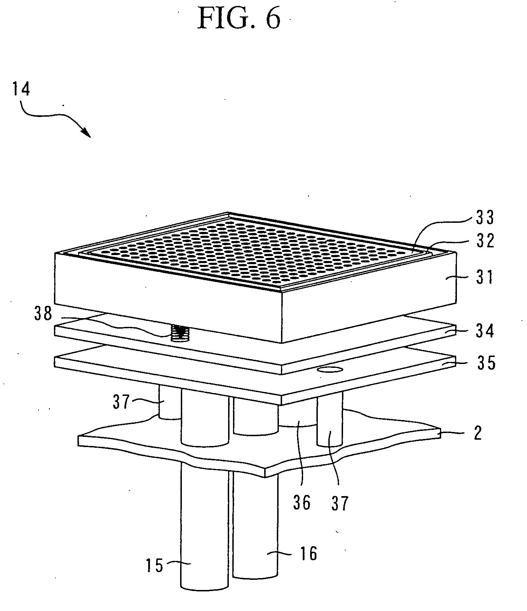

FIG.6 is a perspective view of the cleaning unit 14. In FIG.6, 31 is a gas chamber, 32 is a partition plate installed in the gas chamber 31, and 33 is a gas distributing plate supported by the partition plate 32. All these elements are made of carbon. Also, 35 is a fixed base that is fixed to the base 2 by fixing bars 37. A motor 36, which is described later, is fitted to the fixed base 35, and this motor 36 drives vertically a drive base 34. The gas chamber 31 is coupled to the drive base 34 by springs 38, and thus the gas chamber 31 and the drive base 34 are moved together vertically.

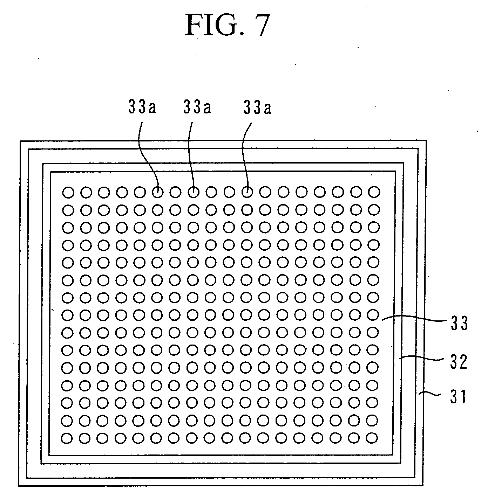

FIG.7 is a top view of this cleaning unit 14. As shown in FIG.7, a plurality of holes 33a are opened in the gas distributing plate 33.

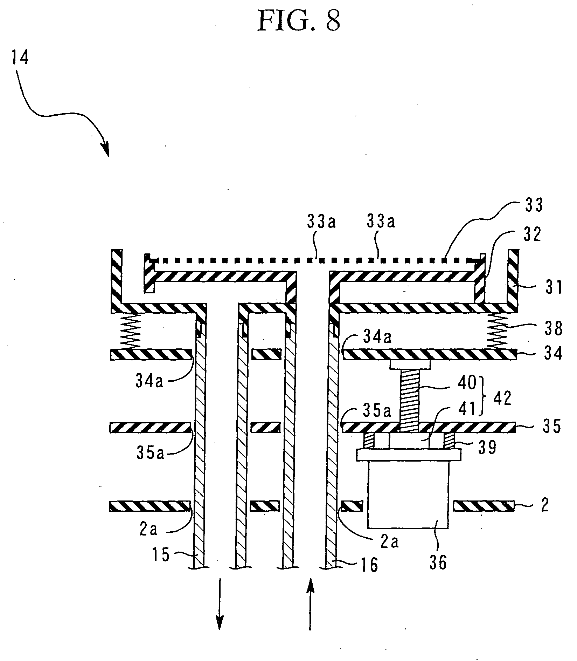

A cross section of this cleaning unit 14 is shown in FIG.8. The motor 36 is fixed to the fixed base 35 by fixing screws 39 and rotationally drives a female screw 41 of a ball screw 42. When the female screw 41 is rotated in this manner, a male screw 40 that is screwed into this female screw 41 is driven vertically, so that the drive base 34 to which this male screw 40 is fixed is also caused to be driven vertically. Then, the gas chamber 31 coupled to the drive base 34 is moved vertically by the rise and fall motion of the drive base 34.

As shown in FIG.8, both the cleaning gas supply pipe 16 and the cleaning gas exhaust pipe 15 are fixed to the gas chamber 31. Opening portions 2a, 35a, and 34a through which the cleaning gas supply pipe 16 and the cleaning gas exhaust pipe 15 pass are opened in the base 2, the fixed base 35, and the drive base 34 respectively. Since clearances are provided between these opening portions 2a, 35a, 34a and the pipe 15,16, the vertical motion of the gas chamber 31 is not prevented. Both the cleaning gas supply pipe 16 and the cleaning gas exhaust pipe 15 are made of carbon.

FIG.9 is view showing routings of a piping system that supplies the cleaning gas. In FIG.9, all elements indicated by a symbol 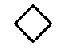 denote switching valves, and all elements indicated by a symbol ○ denote regulators. Also, all elements indicated by a symbol Δ denote check valves for preventing the back flow of the gas. Then, 50, 57 and 58 denote an MFC (mass flow controller) respectively.

Roughly classifying, this piping system consists of a water vapor supply system (water vapor supplying means), an N₂ (carrier gas) supply system, and an HF gas supply system (HF gas supplying means). Among these systems, the water vapor supply system is the system that starts at N₂ bomb 44 and extends to the cleaning unit 6 via an MFC 58, and serves to supply the water vapor to the cleaning unit 6. And the N₂ (carrier gas) supply system is the system that starts at N₂ bomb 44 and extends to the cleaning unit 6 via an MFC 57, and serves to supply N₂ to the cleaning unit 6. And the HF gas supply system is the system that starts at HF bomb 43 and extends to the cleaning unit 6 via an MFC 50, and serves to supply HF gas to the cleaning unit 6. Details of these systems will be described later.

### (2) Explanation of the film forming method using the above CVD equipment

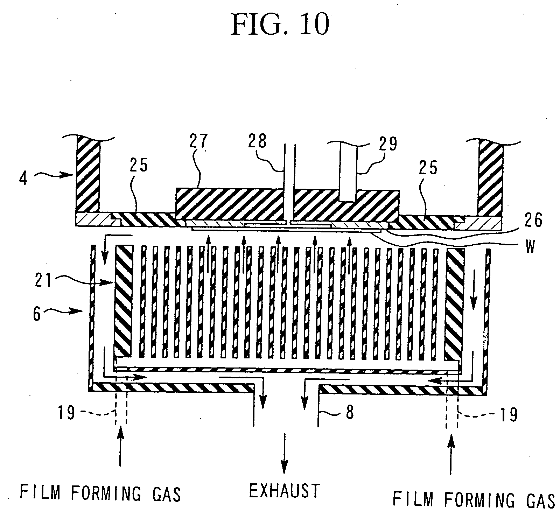

Next, a method of forming the film by using the above- mentioned CVD equipment 1 will be explained hereunder. As explained above, when the film formation is carried out, the carrier 5 and the heater unit 4 position at the position indicated by a solid line in FIG.1. A cross section of the film forming unit 6 and the heater unit 4 at this position is shown in FIG.10. As shown in FIG.10, the back surface of the silicon wafer W is held by the suscepter 26 via the vacuum chuck.

Also, as explained above, the film forming gas is supplied to the film forming unit 6 through the branch pipes 19. An example of this film forming gas is that consists of TEOS (Tetraethoxysilane), N₂, O₂, and O₃. Among these gases, N₂ is the carrier gas of TEOS. The film forming conditions using this film forming gas is as follows.
Temperature of the silicon wafer W 415 (°C)
O₂ flow rate 7.5 (slm)
N₂ flow rate 18.0 (slm)
TEOS/N₂ flow rate 1.5 (slm)
O₃ concentration 130 (g/Nm³)

Under these conditions, the SiO₂ film is formed on the surface of the silicon wafer W.

In the present embodiment, TEOS is supplied to the branch pipes 19 by the bubbling of N₂. The "TEOS/N₂ flow rate" in the above conditions represents the N₂ flow rate in this bubbling. Also, "N" appearing in the unit "g/Nm³" is the abbreviation of "Normal (normal state)", and this "g/Nm³" represents the density in the normal state (0 °C, 1 atmospheric pressure).

This film forming gas is exhausted via the exhaust pipe 8 after it blows against the silicon wafer W. As shown in FIG.10, though a clearance is provided between the heater unit 4 and film forming unit 6, increasing a difference between the internal pressure of the gas distributor 21 and the exhaust pressure (the pressure in the exhaust pipe 8) sufficiently can prevent the film forming gas from leaking to the outside of the semiconductor manufacturing system. Specifically, in the present embodiment, if the above pressure difference is set to 2 mmH₂O to 10 mmH₂O, it is possible to prevent the leakage of the film forming gas. Since the clearance is provided between the heater unit 4 and the film forming unit 6 in this manner, the pressure of the film forming gas on the wafer W coincides substantially with the atmospheric pressure. Therefore, the above process is the so-called atmospheric pressure CVD method.

Also, as can be appreciated from FIG.10, since not only the silicon wafer W but also a part of the suscepter 26 and the protection plate 25 are exposed to the film forming gas, the SiO₂ film is also formed on the suscepter 26 and the protection plate 25. If this SiO₂ film is not removed, the suscepter 26 and the protection plate 25 can no longer perform their predetermined functions. For this reason, this SiO₂ film must be removed periodically. To this end, it is preferable to perform the cleaning method described in the following.

### (3) Explanation of the cleaning method of the above CVD equipment

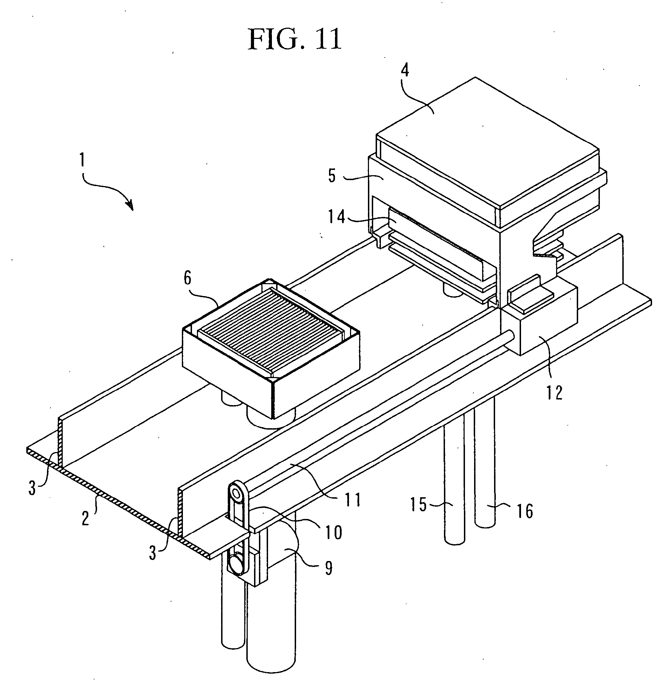

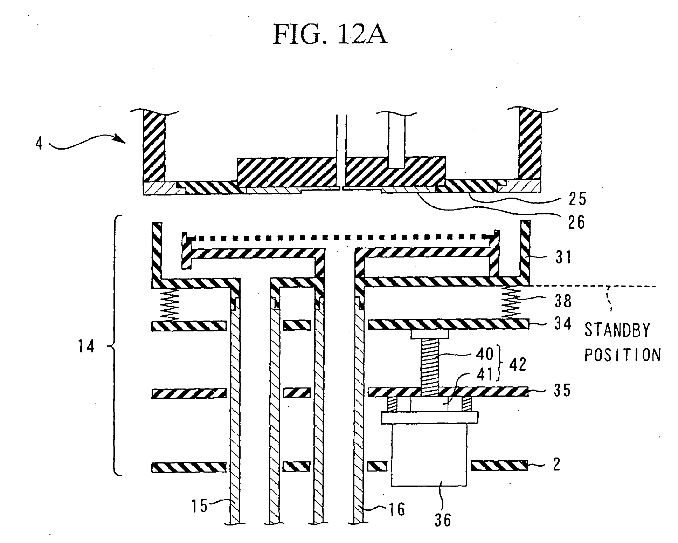

Next, the cleaning method for the above CVD equipment 1 will be explained with reference to FIG.11 and FIG.12A to 12D hereunder. FIG.11 is a perspective view showing the method for cleaning the CVD equipment according to the present embodiment. FIG.12A to FIG.12D are sectional views showing the method for cleaning the CVD equipment according to the present embodiment. In the present embodiment, the suscepter 26 and the protection plate 25, to which the SiO₂ film is adhered, are objects to be cleaned.

### ① Step S1

Firstly, as shown in FIG.11, the carrier 5 and the heater unit 4 are moved together by driving the motor 9 so as to cover the cleaning unit 14 with the heater unit 4. A cross section of the heater unit 4 and the cleaning unit 14 at this time is shown in FIG.12A. As shown in FIG.12A, the heater unit 4 and the cleaning unit 14 are separated from each other and thus the clearance is provided between the gas chamber 31 and the heater unit 4. This position of the gas chamber 31 is called as a standby position in the following. When the suscepter 26 and the protection plate 25 are to be cleaned, the suscepter 26 does not hold the wafer.

### ② Step S2

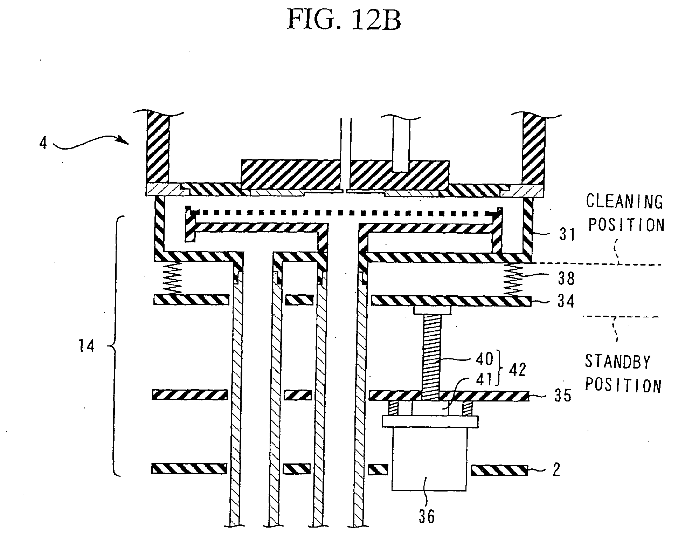

Then, as shown in FIG.12B, the drive base 34 is lifted upward in the vertical direction by driving the motor 36. According to this, the gas chamber 31, which is coupled to the drive base 34 via springs 38, is also lifted upward and comes in contact with the heater unit 4. At this time, the impact generated when the gas chamber 31 hits against the heater unit 4 can be absorbed by the springs 38. According to this step, the space over the gas chamber 31 can be sealed by the heater unit 4.

### ③ Step S3

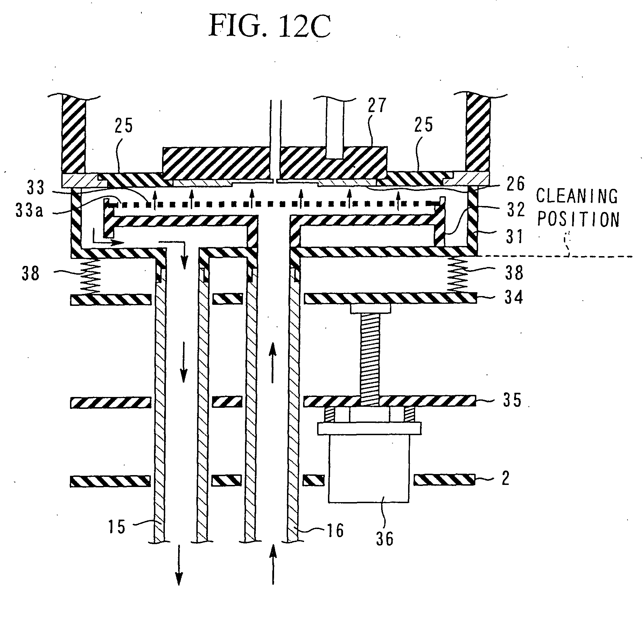

Then, as shown in FIG.12C, the cleaning gas is supplied to the interior of the sealed gas chamber 31 via the cleaning gas supply pipe 16. The supplied cleaning gas is passed through holes 33a of the gas distributing plate 33 and then injected to the protection plate 25 and to the suscepter 26. Then, the injected cleaning gas passes through a space between the partition plate 32 and the gas chamber 31 and then is exhausted via the cleaning gas exhaust pipe 15.

In the present embodiment, a gas mixture consisting of HF gas, water vapor, and N₂ is employed as the cleaning gas. As explained above, since the gas chamber 31, the partition plate 32, the gas distributing plate 33, the cleaning gas supply pipe 16, and the cleaning gas exhaust pipe 15 are all made of carbon, these elements do not corrode by HF even if the cleaning gas containing the HF gas is employed.

Next, a method of supplying the cleaning gas into the gas chamber 31 will be explained by referring again to FIG.9.

When supplying the cleaning gas, the HF bomb 43 is warmed in advance at about 40 to 60 °C by a heater (not shown). In FIG.9, 61 is an H₂O bubbler, whose vessel is filled with H₂O. This H₂O bubbler 61 is also warmed in advance at about 40 to 60 °C by the heater (not shown).

Then, open/close states of the switching valves at this time are set as follows.
"Opened" valves···valves 45, 48, 51, 55, 56, 59, 60
"Closed" valves···valve 47

If the switching valves are set in this manner, the HF gas passes through the routes indicated by a black arrow in FIG.9 and is supplied to the gas chamber 31. Also, the water vapor passes through the routes indicated by a white arrow in FIG.9 and is supplied to the gas chamber 31, and also the N₂ gas passes through the routes indicated by a broken-line black arrow in FIG.9 and is supplied to the gas chamber 31. The valve 47 is used to purge the pipes of the HF gas supply system by the N₂ gas.

As can be appreciated from this, the water vapor is supplied to the gas chamber 31 by bubbling H₂O in the H₂O bubbler 61 using the N₂ gas. In the following, N₂ used for bubbling H₂O, i.e., N₂ supplied via the switching valve 55, is called as the N₂ (bubbler). The water vapor flow rate can be controlled arbitrarily by controlling the N₂ (bubbler) flow rate by the MFC 58. In the following, N₂ used simply for adding the cleaning gas, i.e., N₂ supplied via the switching valve 56, is called the N₂ (carrier gas). Flow rates of the N₂ (carrier gas) and the HF gas can be adjusted arbitrarily by the MFC 57 and the MFC 50 respectively.

On the other hand, in FIG.9, 63 and 64 both denote heaters that envelop the pipes. These heaters 63, 64 function to prevent the water vapor and HF that pass through these pipes from cooling and liquefying. The HF and the water vapor can be supplied to the gas chamber 31 in the gaseous state by using these heaters 63, 64. Also, 53 is a filter that filtrates the gas mixtures consisting of the HF gas and the N₂ (carrier gas).

The cleaning conditions using this cleaning gas is as follows.
· Temperatures of the protection plate 25 and the suscepter 26···200 to 550 (°C)
· HF gas flow rate···1 to 10 (litter/min)
· N₂ (bubbler) flow rate···0.3 to 5.0 (litter/min)
· N₂ (carrier gas) flow rate···1 to 10 (litter/min)

The temperatures of the protection plate 25 and the suscepter 26 (see FIG.12C) can be controlled arbitrarily by the heater 27. According to these conditions, the SiO₂ film formed on both the suscepter 26 and the protection plate 25 can be removed by the following reaction.

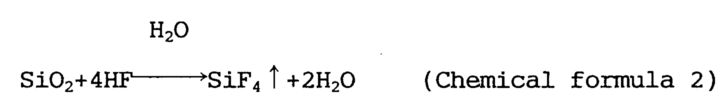

In the above formula, H₂O in the right hand side does not remain on the suscepter 26 and the protection plate 25 since the suscepter 26 and the protection plate 25 are heated. Also, since the boiling point of SiF₄ is -95 °C, SiF₄ in the right hand side does not remain on the suscepter 26 and the protection plate 25. In addition, even if the unreacted HF are existing in the cleaning gas, HF does not remain in the suscepter 26 and the protection plate 25 since the suscepter 26 and the protection plate 25 are heated up to the temperature that is sufficiently higher than the boiling point of HF (20 °C under the atmospheric pressure). As a result, in the present embodiment, there is no necessity that the suscepter 26 and the protection plate 25 be cleaned by the water after the cleaning as in the prior art.

The inventors also found that if the water vapor was added to the cleaning gas as above, HF²⁻ was generated in the cleaning gas and thus the reaction in the chemical formula 2 was accelerated. Moreover, the inventors also found that if the water vapor was added to the reaction too much, the reaction of the chemical formula 2 proceeded in the leftward direction and hence SiO₂ regenerated. Accordingly, it is preferable to make the amount of the vapor in the cleaning gas sufficiently high so as to accelerate the reaction of the chemical formula 2, and to make it sufficiently low so as to prevent the reaction from proceeding in the leftward direction.

By the way, though the cleaning gas which is subjected to the above reaction is exhausted from the exhaust pipe 15 as the exhaust gas, the liquid component is hardly contained in this exhaust gas. The reasons for this are that an amount of the water vapor added to the cleaning gas is minute and that both the HF and the SiF₄ in the exhaust gas are gaseous at the room temperature (20 °C) (Note that the boiling point of the HF is 20 °C under the atmospheric pressure).

Therefore, the exhaust gas, which scarcely contains the liquid component, can be processed by an adsorption-type exhaust gas processing system 65 (referred simply to as a "exhaust gas processing system" hereinafter) shown in FIG.9. The adsorption-type exhaust gas processing system 65 includes alkaline adsorbate. The exhaust gas processing system 65 permits the alkaline adsorbate to adsorb harmful components contained in the exhaust gas, such as SiF₄, HF, and the like, thereby removes these harmful components. It should be noted that though the adsorbate can remove the harmful components in the gas, it cannot remove the harmful components contained in the liquid. Therefore, the exhaust gas processing system 65 cannot be employed in the prior art where the HF aqueous solution is used.

In general, an amount of waste product discharged from the adsorption-type exhaust gas processing system 65 is extremely smaller than that discharged when the waste HF aqueous solution is processed in the prior art. Therefore, in the present embodiment, since an amount of the waste product can be reduced than the prior art, it is possible to reduce the possibility that the environment, in which human beings live, is polluted by the waste product.

### ④ Step S4

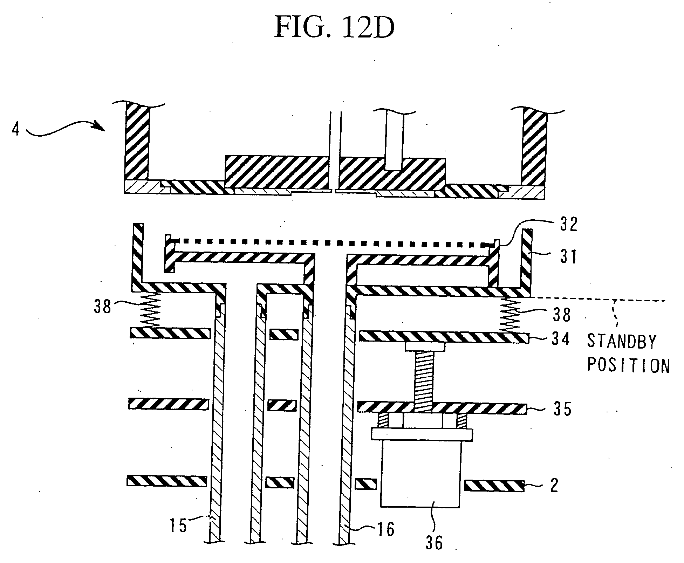

After the cleaning is carried out as above, the supply of the cleaning gas is stopped. Then, as shown in FIG.12D, the gas chamber 31 is brought down to the standby position again by driving the motor 36. According to the above, the cleaning of the suscepter 26 and the protection plate 25 has been completed. As explained above, since the cleaning gas and the coproduct generated in the cleaning do not remain on the suscepter 26 and the protection plate 25, there is no need to rinse these elements with water as in the prior art. Therefore, after the step S4 is completed, the film formation can be carried out by simply returning the heater unit 4 and the carrier 5 to the positions shown in FIG.1.

In this manner, according to the CVD equipment 1, when the film is to be formed on the wafer, the heater unit 4 (containing the suscepter 26) is moved to the position at which the wafer is exposed to the film forming gas discharged from the film forming unit 6. Then, when the suscepter 26 and the protection plate 25 are to be cleaned, the heater unit 4 (containing the suscepter 26) is moved to the position at which such heater unit 4 (containing the suscepter 26) is exposed to the cleaning gas discharged from the cleaning unit 14. According to this, when the suscepter 26 and the protection plate 25 are to be cleaned, there is no need to remove the suscepter 26 and the protection plate 25 from the heater unit 4. Therefore, maintenance time for the system can be reduced than the prior art.

Though the present embodiment is explained in detail in the above, the present invention is not limited to the present embodiment. For example, though the SiO₂ film adhered to the object (the suscepter 26 and the protection plate 25) is formed by the atmospheric pressure CVD method in the above, the SiO₂ film formed by the plasma CVD method, the low pressure CVD method, etc. can also be removed by the similar method to the above. Also, the silicon oxide film is not limited to the SiO₂ film. Even when the silicon oxide film such as the BPSG film, the PSG film, the FSG film, or the like is adhered to the object, such silicon oxide film can be cleaned by the similar method to the above. In addition, the present invention can be modified without departing from its spirit.

## Claims

1. A method for cleaning a semiconductor manufacturing system comprising:
removing a silicon oxide that adheres on a object by exposing the silicon oxide to a cleaning gas containing an HF gas and a water vapor along with heating the object.

2. A method according to claim 1, wherein the water vapor is generated by bubbling a water.

3. A method according to claims 1 or 2, wherein the silicon oxide is any one of SiO₂, BPSG, PSG, and FSG.

4. A method according to any one of claims 1 to 3, wherein the object constitutes the semiconductor manufacturing system (1).

5. A method according to claim 4, wherein the object is a suscepter (26) that holds a wafer (W).

6. A semiconductor manufacturing system comprising:
a film forming gas discharging means (6);
a cleaning gas discharging means (14); and
a wafer holding means (26) that moves between the film forming gas discharging means (6) and the cleaning gas discharging means (14);
wherein, when forming a film on a wafer (W), the wafer holding means (26) moves to a position at which the wafer (W) is exposed to a film forming gas discharged from the film forming gas discharging means (6), and
when cleaning the wafer holding means (26), the wafer holding means (26) is moved to a position at which the wafer holding means (26) is exposed to a cleaning gas discharged from the cleaning gas discharging means (14) in such a condition that the wafer holding means (26) does not hold the wafer (W).

7. A semiconductor manufacturing system according to claim 6, further comprising:
a water vapor supplying means for supplying a water vapor to the cleaning gas discharging means (14); and
an HF gas supplying means for supplying an HF gas to the cleaning gas discharging means (14).

8. A semiconductor manufacturing system according to claim 7, further comprising:
a heating means for heating the wafer holding means.

9. A semiconductor manufacturing system according to claim 7, wherein the water vapor supplying means has a means (61) for generating the water vapor by bubbling a water.
